# EUROPEAN PATENT SPECIFICATION

(11) **EP 0 617 464 B1**
(45) Date of publication and mention of the grant of the patent: **22.05.2002**
(21) Application number: 94103166.8
(22) Date of filing: 03.03.1994
(51) Int. Cl.: H01L 23/495

(54) **Semiconductor device having X-shaped die support member and method for making the same**
Halbleiteranordnung bestehend aus einem X-förmiger Montierungsrahmen und dessen Herstellungsverfahren
Dispositif semi-conducteur ayant un support en forme de croix et procédé de fabrication

(30) Priority: 22.03.1993 US 35422; 12.10.1993 US 133947
(43) Date of publication of application: 28.09.1994
(73) Proprietor: MOTOROLA, INC., Schaumburg, IL 60196 (US)
(72) Inventor: Djennas, Frank, Austin, Texas 78759 (US); Poku, Isaac T., Austin, Texas 78729 (US); Yarosh, Robert, Austin, Texas 78745 (US)
(74) Representative: Hudson, Peter David

(56) References cited:
- JP-A- 4 363 056
- JP-A- 61 110 454
- US-A- 5 229 638
- PATENT ABSTRACTS OF JAPAN vol. 012 no. 489 (E-696) ,21 December 1988 & JP-A-63 204753 (NITTO ELECTRIC IND CO LTD) 24 August 1988
- PATENT ABSTRACTS OF JAPAN vol. 009 no. 208 (E-338) ,24 August 1985 & JP-A-60 072236 (TOSHIBA KK) 24 April 1985
- PATENT ABSTRACTS OF JAPAN vol. 012 no. 318 (E-650) ,29 August 1988 & JP-A-63 081966 (HITACHI LTD) 12 April 1988
- PATENT ABSTRACTS OF JAPAN vol. 014 no. 255 (E-0935) ,31 May 1990 & JP-A-02 074065 (MATSUSHITA ELECTRON CORP) 14 March 1990

## Description

### Field of the Invention

The present invention relates generally to semiconductor devices, and more specifically to semiconductor devices which utilize X-shaped die supports in semiconductor packages, and methods for making the same.

### Background of the Invention

Package cracking is a common problem in plastic encapsulated semiconductor devices. The problem arises from a combination of factors. One factor is an internal delamination between the plastic encapsulant material and a flag of a lead frame. The flag is a plate-like member of a conventional lead frame which supports the die. The flag, like the rest of the lead frame, is usually made of copper, a copper-alloy, or an iron-nickel alloy, and therefore has a coefficient of thermal expansion (CTE) which in most instances is different than that of the surrounding molding compound or plastic. As a result of this CTE mismatch, stress is created at the plastic-flag interface as the semiconductor device experiences temperature changes. The stress, upon reaching a maximum threshold, is relieved through delamination of the plastic-flag interface. Another factor involved in package cracking is moisture absorption. After the plastic-flag interface becomes delaminated, moisture from the environment diffuses through the molding compound to the delaminated area. Once moisture accumulates in the package, rapid temperature increases will cause the moisture to vaporize and expand, thereby creating an internal pressure pocket in the delaminated area. To relieve the pressure and associated stress, the surrounding plastic cracks. The most common occurrence of package cracking occurs when a user attaches a plastic semiconductor device to a substrate using a solder reflow operation. The rapid increase and high temperatures associated with solder reflow are often sufficient, depending on the moisture content of the device, to cause the plastic to crack.

There are numerous existing methods of dealing with the problem of package cracking. One method is dry-packing, which involves baking plastic encapsulated semiconductor devices sufficiently to reduce moisture content and packaging the devices into moisture resistant packets. Device users then attach the device before a sufficient amount of moisture to cause cracking can be absorbed into the package through exposure to ambient conditions. This method is effective, but significantly increases the costs of semiconductor devices. Moreover, device users must keep track of how long devices have been exposed to the ambient conditions to assure that any absorbed moisture is insufficient to cause cracking problems.

Other known approaches have tried to decrease the possibility of internal delamination through improved adhesion between flag and the plastic. For example, some manufacturers have "roughened" the metallic surface of the flag to improve adhesion. Others have formed small holes or dimples in the flag to provide anchoring mechanisms. Another approach used to improve adhesion is the use of a window-frame flag. A window-frame flag is more or less a hollowed-frame that supports the die, rather than a solid paddle.

The methods described above do, to some extent, decrease the possibility of delamination by providing better adhesion to the plastic encapsulating material. Similarly, the present invention has the advantage of reduced delamination, albeit through a technique not previously used. But in addition, the present invention addresses another manufacturing problem which the above methods do not address, namely the need for semiconductor manufacturers to use a different or customized lead frame design for each of its products. Having a different lead frame design for each die size and die functional pin-out necessitates a large inventory of piece-parts and requires additional time and human resources to design a new lead frame before each product introduction. In addition to costs associated with inventory and design, the cost of the lead frames themselves are undesirably inflated because of insufficient volume to lower the cost to a minimum. Several small orders for lead frames, each requiring separate tooling, is more costly than one order for the same total number of lead frames. Thus, the cost of semiconductor manufacturing could be significantly reduced by the use of a lead frame design which could be used in conjunction with several different die sizes. The present invention achieves this goal by utilizing a lead frame in a semiconductor device which can be used with various die sizes, while at the same time improving adhesion between the lead frame and the encapsulating material to alleviate package cracking problems.

JP-A- 63-204753 includes a lead frame as seen in Figure 1 that includes tie bars 2 that have a substantially uniform width along their entire length. US-A-5 229 638 includes a lead frame that has step portions 20. The step portions 20 typically lie along the sides of leads 3, which are the leads closest to the die pad suspension leads 9 (See FIGs. 1-8 and related text). FIG. 9 shows step portion 20 that forms a bridge between the die pad suspension lead and inner lead 3. However, the bridge between the die pad suspension lead 9 and inner lead 3 can be removed as shown in FIG. 10 and related text.

### Summary of the Invention

In one form of the present invention, there is provided a semiconductor device as recited in claim 1 of the accompanying claims. A method for making such a semiconductor device is also included.

These and other features of the present invention will be more clearly understood from the following detailed description taken in conjunction with the accompanying drawings. It is important to point out that the illustrations may not necessarily be drawn to scale, and that there may be other embodiments of the present invention which are not specifically illustrated.

### Brief Description of the Drawings

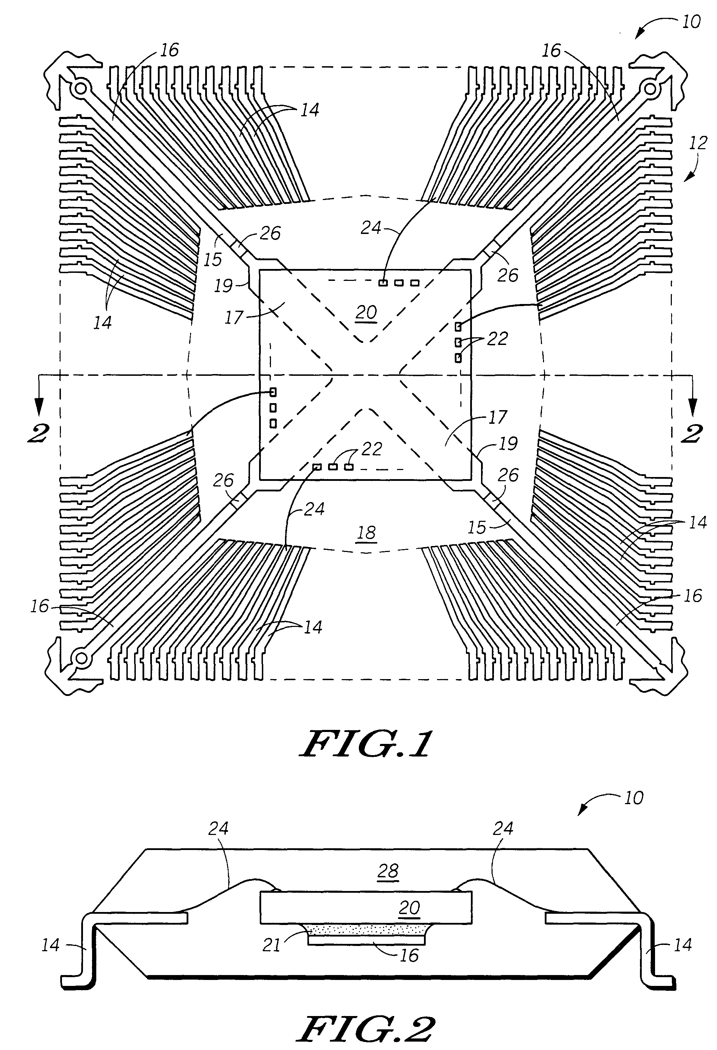

FIG. 1 is a top-down plan view of portions of an unpackaged, flagless semiconductor device in accordance with the present invention.

FIG. 2 is a cross-sectional view of the semiconductor device of FIG. 1 taken along the line 2-2, as packaged in plastic.

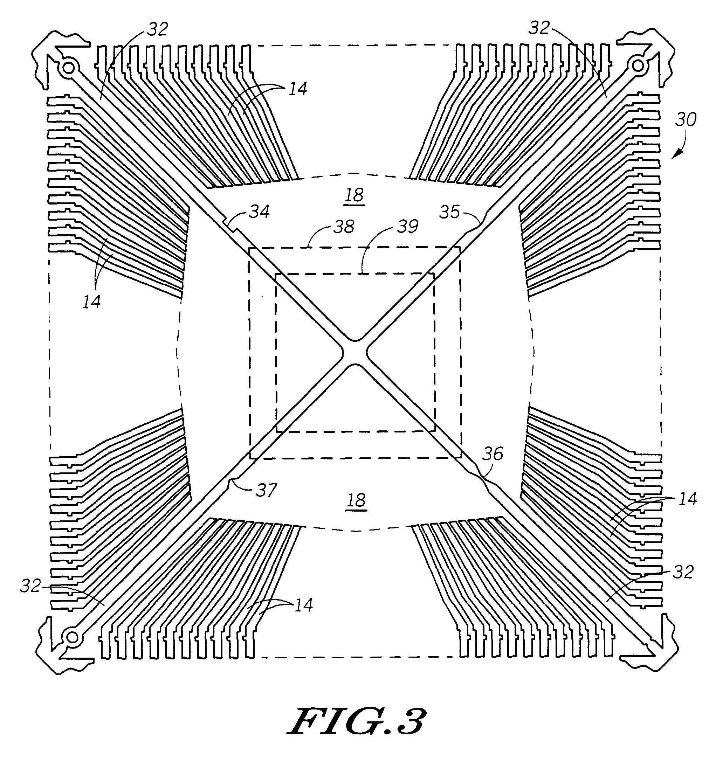

FIG. 3 is a top-down plan view of portions of an alternative lead frame design suitable for use in the present invention.

FIG. 4 is a top-down plan view of portions of yet another lead frame design which utilizes a mini-flag.

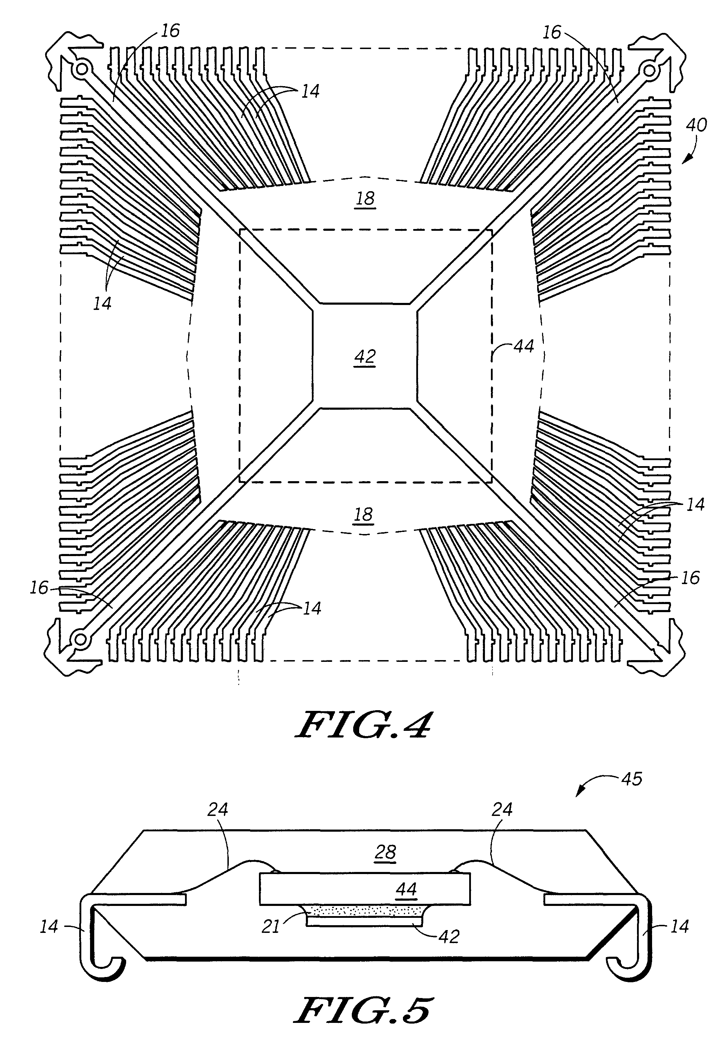

FIG. 5 is a cross-sectional view of a packaged semiconductor device which utilizes the lead frame of FIG. 4.

FIG. 6 is a top-down view of portions of an alternative lead frame design having a mini-flag.

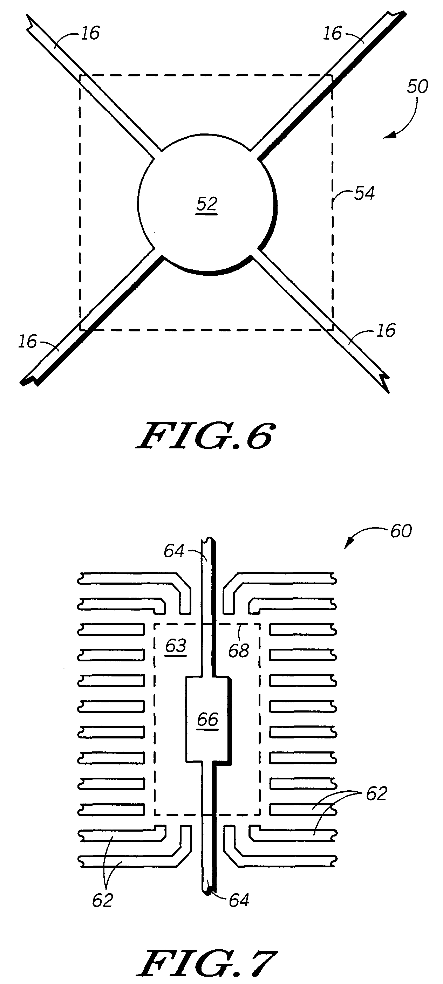

FIG. 7 is a top-down view of portions of yet another lead frame design having a mini-flag.

### Detailed Description of a Preferred Embodiment

The present invention combines the attributes of a universal lead frame, that is one that is usable with several different die sizes, with the advantage of reduced delamination between the lead frame and an encapsulating material. Thus, the present invention alleviates the problem of package cracking. FIG. 1 illustrates these advantages in a top-down plan view of one embodiment of the present invention. A semiconductor device 10 has portions of a lead frame 12 which include a plurality of leads 14 and four tie bars 16. Lead frame 12 of FIG. 1 is only partially illustrated. As one of ordinary skill in the art would understand, leads 14 and tie bars 16 extend to two opposing rails (not illustrated) as in a conventional strip lead frame. In addition, not, all of the leads of lead frame 12 are illustrated. But for the purposes of understanding the present invention, the remaining portions need not be illustrated. The plurality of leads 14 each have inner lead portions which together define a die receiving area 18 within the device. The particular lead frame illustrated in FIG. 1 is for use in a QFP (quad flat pack) semiconductor package; however, it is important to realize the present invention is not limited to such a package type, as will become evident later in the description. In the QFP design, each tie bar 16 originates at a corner of device 10 and extends into die receiving area 18 until converging with the other tie bars to form an "X". In one alternative embodiment, tie bars 16 could extend from opposing sides of the die receiving area to form a "+" as viewed from the perspective of FIG. 1.

Mounted onto tie bars 16 is a semiconductor die 20. A conventional die attach adhesive 21, illustrated in a cross-sectional view of device 10 in FIG. 2, is used to mount die 20 to tie bars 16. Die 20 is typically an integrated circuit, such as a microprocessor, a memory, an analog device, or the like, which is fabricated on silicon or another semiconducting substrate. Die 20 includes a plurality of conductive bond pads 22 used to electrically access portions of the integrated circuit through various conducting layers (not shown) of the die. The electrical accessibility to the circuit is extended externally through a combination of conventional wire bonds 24 and leads 14. Wire bonds 24 electrically couple bonds pads 22 to respective leads 14. As depicted in FIG. 2, leads 14 extend outside of a package body 28 to provide external accessibility to the end device user.

In accordance with the invention, tie bars 16 each have two distinct portions with different widths. A first portion 15 having a first width extends from the rails (not shown) into die receiving area 18. A second portion 17 actually supports die 20. Portions 17 each have a second width which is larger than the first width. In one embodiment of the present invention, the width of each first portion 15 is on the order of 0.2-0.3 mm (8-12 mils) while the width of each second portion is on the order of 1.0-1.5 mm (40-60 mils). The reason for the two different widths is not that die 20 cannot be supported by a narrower tie bar. As will become evident in FIG. 3, it is the configuration of the tie bars, not the width, that establishes adequate die support strength and stability. Instead, the reason two tie bar portions having different widths is used is to establish "shoulders" 19. Shoulders 19 provide a reference point used to align die 20 on the tie bars. Vision-based die bonding equipment can easily locate shoulders 19, thereby enabling accurate placement of die 20 onto the tie bars. As illustrated, each shoulder 19 is approximately parallel with a side of die 20. Features other than shoulders 19 can be used to aid in die mounting, as will also become evident in FIG. 3, but do not form part of the claimed invention.

FIG. 1 demonstrates the universal aspect of device 10. Due to the configuration of tie bars 16 of lead frame 12, several different semiconductor die sizes and shapes can be used. Conventional devices typically employ lead frames having a flag, onto which a semiconductor die is mounted. The flag is made slightly larger than the die to provide a large die bonding area, thereby maximizing the adhesion between the die and the flag. In using such a flag, a semiconductor manufacture restricts which die can be used in the device. Thus for different die shapes and sizes, the manufacture must design a new lead frame. As discussed previously, new designs delay product introductions and add to manufacturing costs.

A device in accordance with the present invention eliminates many new lead frame designs in comparison to traditional methods. As illustrated in FIG. 1, device 10 does not employ a flag. Instead, die 20 rests on tie bars 16. Due to the configuration of tie bars 16, nearly any size or shape of die can be supported. A limitation to the die size and shape of die 20 is imposed by inner portions of leads 14 which define die receiving area 18. Another limitation to the die size used with lead frame 12 may be wire bond length. As the die size becomes smaller, the length of wire bonds 24 needed to electrically couple the die to leads 14 increases. Thus, a manufacturer's upper limit on wire bond length will also set a lower limit on die size.

Further limitations to die size can be imposed by features in the tie bars. For instance, if shoulders 19 or other alignment features are used, mounting a die on the tie bars which covers the alignment features may defeat their initial purpose. However, use of shoulders or other alignment features does not prohibit variable dies sizes from being used. Although the distance from an alignment feature to the die may vary with different die sizes, several different die sizes can still be used with the same lead frame design. For example, die sizes smaller than die 20 can still be mounted onto tie bars 16. Another tie bar feature which limits die size may be down-set regions, such as down-set regions 26 illustrated in FIG. 1. Portions 15 of the tie bars are approximately planar with leads 14, whereas portions 17 are in a lower plane as a result of down-set regions 26. The down-set feature is also illustrated in FIG. 2, a cross-sectional view of device 10, as packaged, taken along the line 2-2 of FIG. 1. Down-set tie bars are used to lower the position of the die in comparison to leads to facilitate wire bonding. If tie bars 16 are designed to include down-set regions, the size of die 20 is further limited to an area within the down-set region to avoid mounting the die on non-coplanar tie bars.

The cross-section of FIG. 2 aids in understanding how device 10 is also more resistant to package delamination when compared to devices which use conventional lead frames and flags. Device 10 as illustrated in FIG. 2 is packaged in a plastic resin package body 28. Package body 28 is formed about the device using traditional plastic encapsulation methods. But unlike traditional plastic packages, package body 28 is less prone to cracking because die 20 is supported by tie bars 16. (In FIG. 2 it appears that only one tie bar supports the die because the cross-section is taken where all the tie bars converge to one point.) The reason why package body 28 is less prone to cracking is because the total interface area between the plastic encapsulant material and the die support (in this case, tie bars 16) is much less than the interface area in conventional devices. For the purposes of this discussion, the interface between the die support member and the plastic is referred to as the plastic-metal interface rather than the plastic-flag interface since not all embodiments of the present invention have a flag. In conventional devices which employ a flag, the plastic-metal interface within the die receiving area is equal to the area of the flag, which is slightly more than the area of the die. In device 10, on the other hand, the plastic-metal interface area is considerably less, being equal to the surface area of the tie bars.

The improvement in package cracking performance in device 10 and other embodiments of the present invention is attributable to improved adhesion properties. As discussed previously, delamination traditionally occurs between a flag and the plastic packaging material because of high stress and inherently poor adhesion between the lead frame metals and conventional plastic encapsulation materials. The present invention improves the delamination problem by minimizing the plastic-metal interface area, thereby minimizing the potential delamination area. Decreasing the interface area between the lead frame and plastic results in an increase in the interface area between the plastic packaging and the backside of the semiconductor die, herein referred to as the plastic-die interface. The increase in the plastic-die interface area is advantageous because adhesion between plastic encapsulation materials and silicon (the most common semiconductor die material) is stronger than the adhesion between plastic and most lead frame metals. Accordingly, delamination is less likely to occur at the plastic-die interface than at the plastic-metal interface.

In accordance with preferred embodiments of the present invention, the total area of the tie bars or die support member is minimized to increase the plastic-die interface area. To decrease the total tie bar or die support area, the width of individual tie bars is minimized. In conventional packages, tie bar widths used to support a flag range from about 0.20-0.65 mm (8-16 mils), usually being on the order of 0.4-0.5 mm (15-20 mils). Such tie bar widths are well suited for use in the present invention. However, as explained earlier in reference to FIG. 1, there may be advantageous reasons to slightly widen the tie bars. As illustrated in FIG. 1, the tie bars are widened to create shoulders for die alignment purposes. Yet another reason for widening tie bars from the standard tie bars widths recited above is related to die attaching processes.

Most semiconductor die are attached to flags of conventional devices using a die attach epoxy (such as a silver-filled epoxy). Traditionally, the epoxy is dispensed on the flag in a predetermined dot or line pattern which is designed to adequately attach the die to the flag without voids and with an appropriate degree of fillet around the die edge. In the present invention, it may be advantageous to choose the width of the tie bars to fit a manufacturer's existing die attach process and equipment. For instance, a particular epoxy dispensing system may have a lower limit on the amount of epoxy it can dispense, based on the size of the syringe used to dispense the material. As an illustrative example, the smallest epoxy "dot" that a system can dispense may be about 0.4-0.5 mm (15-20 mils) in diameter. Upon pressing the die against the die support member, the epoxy spreads. Therefore, to prevent overflow of a die attach material over the edges of the tie bars, one practicing the present invention may choose a tie bar width sufficient to contain the spread of the die attach material.

In preferred embodiments, a die attach material is dispensed in an X-shaped dot pattern having a single row of dots per tie bar. In many commercially available die attach dispensing systems, the diameter of the dispensing syringe is on the order of 0.4-0.5 mm (15-20 mils). Viscosity, die bonding pressure, temperature, and other process parameters will affect the degree of spread in the die attach material during die bonding. However, with the single row of dots in an X-shaped pattern, the spread of the die attach material using most commercially available dispensing systems can be easily contained with a tie bar width of 1.5 mm (60 mils). As manufacturing processes, materials, and dispense system equipment evolve, it is believed that much smaller tie bar widths can be used with these dispense systems. Furthermore other methods of die attachment can be used on narrower tie bars which do not have such dispense limitations. For example, a die may be attached to tie bars using an adhesive tape. Thus, the present invention may be practiced using tie bars widths ranging anywhere from more standard tie bar widths on the order of 0.2 mm (0.8 mils) to wider widths of 1.5 mm (60 mils) while maintaining the ability to resist package cracking since the total metal-plastic interface area is much smaller than in prior art devices. To minimize the metal-plastic interface area, these width ranges should represent that widest portion of the device tie bars. Thus, the maximum tie bar width, in accordance with preferred embodiments of the present invention, is less than approximately 1.6 mm (63 mils).

It is worth noting that as the die size is decreased, the adhesion area between the die and the plastic is reduced, so that even if tie bars used to support the die are made as narrow as possible, the adhesion between the die and the plastic may be insufficient to resist package cracking. Although as die size is reduced, overall stress in the package is also reduced. This suggests that the present invention, for the purpose of preventing package cracking, is more effective for relatively large die (although die of all sizes can be used while still reaping the benefits of the present invention). As an example, the present invention is quite suitable for die having an area of 3.8 mm (150 mils) square or larger and preferably for die having an area of 6.5 mm (250 mils) square or larger. With die areas of this size, and the tie bars widths specified above, the interface area between the die and the plastic package is greater than or equal to the interface area of the metal tie bars and the plastic package. Therefore, rather than defining tie bar width as an important dimension in practicing the present invention, it may also be important to compare the total die-plastic interface area and the metal-plastic interface area. Generally stated, the die-plastic interface area should be greater than the metal-plastic interface (excluding the interface between the leads and the plastic). In preferred embodiments, the die-plastic interface area is greater than two times the metal-plastic interface.

FIG. 3 illustrates portions of a lead frame 30 in a top-down plan view. Lead frame 30 has various features which can be used in a semiconductor device in accordance with the present invention but does not fall within the scope of the claimed invention. Similarly, lead frame 30 has many features in common with lead frame 12 of FIG. 1. Accordingly, like numerals in each of the figures represent the same or similar elements. Four tie bars 32 of lead frame 30 extend across die receiving area 18 to form an X-shaped die support (a semiconductor die is not illustrated in FIG. 3). Unlike tie bars 16 in FIG. 1, each tie bar 32 has a substantially constant width throughout die receiving area 18, and the width of tie bars 32 is smaller than those of tie bars 16. The advantage in using narrower tie bars 32 over tie bars 16 is that with tie bars 32 there is a smaller plastic-metal interface area, thereby lowering the chances of delamination and package cracking. One the other hand, tie bars 32 do not have shoulders to aid in die alignment. However, other features can be incorporated into tie bars 32 to assist in die mounting. A few of the possible types of features suited for this are illustrated in FIG. 3 as alignment features 34, 35, 36, and 37. An alignment feature is included in each of tie bars 32 to represent various types of alignment features which might be implemented. However, it is important to note that any number of tie bars can incorporate any number or type of alignment feature. FIG. 3 also illustrates the universal nature of lead frame 30, showing that two different die sizes (represented in phantom as lines 38 and 39) can be used in conjunction with the same lead frame.

Also note that in FIG. 3, corners of a die are coincident to the tie bars. This alignment is believed to reduce stress concentrations at the die corners in the packaged device since the sharp corners of the die are not completely exposed, rather they are protected from beneath by a tie bar.

For additional die support and die attach area in a semiconductor device of the present invention, a "mini-flag" can be incorporated into the tie bars. FIG. 4 illustrates, in a top-down plan view, portions of a lead frame 40 having such a mini-flag 42 that is useful for understanding the present invention. Mini-flag 42 is kept smaller in area than a semiconductor die (illustrated in phantom as line 44) to keep the total interface area between the mini-flag and a plastic encapsulation material (not illustrated) smaller than in conventional devices. The tie bar dimensions of lead frame 40 are the same as those discussed above. The dimensions of the mini-flag can be optimized to meet processing and reliability requirements of a particular manufacturer. As a general rule, however, the area of mini-flag 42 should be less than 50 percent of the area of a semiconductor die mounted thereto. But, the comparative area of the mini-flag and die specified may be met for some semiconductor die and not for others. In deciding how large or how small to make mini-flag 42, it is important to keep in mind that as the size of mini-flag increases, the plastic-metal interface area increases and consequently the possibility of delamination and package cracking increases. FIG. 5 is a cross-sectional view of lead frame 40 incorporated into a semiconductor device 45. Other elements of device 45 are similar to or are the same as other elements discussed in reference to previous embodiments and are thus labeled with the same reference numerals.

Use of a mini-flag still maintains the universal nature of a semiconductor device in accordance with the present invention since a number of different die sizes can be used with the same lead frame. A semiconductor device using a mini-flag removes previous constraints on flag size, and also on flag shape. For instance, as illustrated in FIG. 6, portions of a lead frame 50 (only partially illustrated) can include a round mini-flag 52 to support a larger die (illustrated in phantom as line 54).

Use of a mini-flag can also be used in conjunction with semiconductor devices which employ less than four tie bars, for example as demonstrated in FIG. 7. A lead frame 60 (only partially illustrated) has a plurality of leads 62, the inner portions of which define a die receiving area 63. Extending across die receiving area 63 are two tie bars 64. Lead frames which include two tie bars extending from opposing sides of the die receiving area are most commonly used in PDIP (plastic dual-in-line) devices. Like in previous lead frame illustrations, not all portions of the lead frame 60 are illustrated. For instance, one of ordinary skill in the art would realize that the tie bars and leads extend to rails of a lead frame strip, but neither the entire stripe nor the rails are illustrated. Incorporated into tie bars 64 is a mini-flag 66 which is made to have an area smaller than the area of a semiconductor die mounted thereto (illustrated in phantom as line 68). Use of a mini-flag allows several different die sizes to be mounted onto mini-flag 66 without having to re-design the entire lead frame, thereby saving manufacturing costs. The reduced area of mini-flag 66 results in a smaller plastic-metal interface, in comparison to conventional devices, once the lead frame is encapsulated by plastic. Thus, delamination and package cracking problems are less likely.

In practicing the present invention it may be necessary to modify existing semiconductor device assembly procedures. One likely modification is the need to change a print pattern for applying die attach adhesive (e.g. adhesive 21 in FIGs. 2 and 5) to die support members of a lead frame. In using a traditional lead frame with a flag larger than the semiconductor, an adhesive material is usually applied in a predetermined pattern through a dispense head onto the flag. In practicing the present invention, the die attach adhesive pattern is now limited to, for example in device 10 of FIG. 1, the tie bar portions 17 beneath the die. Therefore, tooling modifications for adhesive dispense heads may be necessary. Also, the amount of die attach adhesive dispensed is reduced since the die support area is smaller. Tighter process control may also be needed for a couple of reasons. Since the die overhangs die support member (either tie bars or a mini-flag), it is important that the die attach adhesive not spread beyond the die support member when attaching a semiconductor die to prevent the adhesive from contaminating the tooling platform. Another reason to control the amount of die attach adhesive is to provide the proper fillet. In conventional semiconductor device, a fillet of die attach adhesive is formed around the periphery of the semiconductor die. In the present invention, the fillet surrounds the periphery of the die support member. A suitable fillet for a die attach adhesive used in accordance with the present invention is illustrated in FIGs. 2 and 5.

Another processing modification may be useful during wire bonding. Since a semiconductor die is not fully supported along the die periphery, it may be advantageous to provide peripheral die support during wire bonding. Bond pads are generally, but not always, located around the periphery of the die. Thus, to bond a wire to each bond pad, a wire bonding tool must exert pressure on the die perimeter each time it forms a bond. If the wire bonding force is high enough, or alternatively if the die is not flexible enough, there is a risk that the force exerted will cause an unsupported portion of the die to crack or chip. Therefore, it may be desirable to incorporate a support mechanism into the wire bonding platform. For instance, the platform may be designed to include a cut-out which matches the pattern and thickness of the tie bars (and if included the mini-flag) so together the platform and tie bars (and if included the mini-flag) form a substantially planar and continuous surface. As a result the entire die would be supported by a combination of the tie bars and platform during the wire bonding operation. A further advantage of having the die supported by a planar and continuous surface is to achieve even heating of the die during the wire bonding operation. It is important to note that modifications to existing wire bonding operations may not be needed in practicing the present invention. The need for modifications will depend on various factors, including bonding force, die thickness, die size, and bond pad location to name a few.

The foregoing description and illustrations contained herein demonstrate many of the advantages associated with the present invention. In particular, it has been revealed that delamination and package cracking in semiconductor devices can be abated through minimizing internal plastic-metal interfaces. This is accomplished in accordance with the present invention by either eliminating a conventional flag altogether and using tie bars to support a semiconductor die, or alternatively by using a mini-flag which is smaller in area than the die. By reducing the possibility of package cracking, semiconductor manufacturers can move away from expensive dry-packing procedures. Moreover, the present invention helps to solve a manufacturing problem associated with die-specific lead frame design. The die support members used in devices of the present invention will support die of various sizes, such that a new lead frame need not be designed for each type of die. Thus, manufacturing costs, including design and inventory costs, are reduced.

It is therefore apparent that there has been provided, in accordance with the invention, a semiconductor device having a universal, low stress die support, and method for making the same, that fully meets the need and advantages set forth previously. Although the invention has been described and illustrated with reference to specific embodiments thereof, it is not intended that the invention be limited to these illustrative embodiments. Those skilled in the art will recognize that modifications and variations can be made without departing from the scope of the invention. The invention is not limited to any particular number of tie bars to support a die. There is confusion in terminology as to the number of tie bars a particular device has. For instance in FIG. 7, one might say lead frame 60 has one tie bar. To avoid confusion, the number of tie bars recited with respect to the present description refers to the number of places the tie bars are connected to rails of the lead frame. This is analogous to the number of places in which a tie bar is excised from a lead frame, to become flush with an edge or side of a package body. Thus for purposes herein, there are two tie bars in lead frame 60, regardless of the presence of mini-flag 66, because the tie bars connect with rails (not illustrated) in two places. In any event, the number of tie bars used is not as important as the nature of the tie bar configuration. For example, in a preferred embodiment, the tie bar(s) form a die support member which is continuous across the entire die receiving area. In using a mini-flag in accordance with the present invention, the mini-flag can be modified using any of several known methods to also improve package cracking performance. For instance, the mini-flag can include dimples or small holes to improve adhesion. Furthermore, a mini-flag can be a window-frame mini-flag. It is also important to note that the present invention is also adaptable to semiconductor devices employing a die-down configuration. In other words, a die may be mounted to tie bars (or a mini-flag) such that the active surface of the die is adjacent the die support. Such adaptations are within the scope of the present invention. In addition, the present invention is not limited by any type of external lead configuration (e.g. J-lead, gull-wing, or through-hole) of package configuration (e.g. QFP, PDIP, etc.). Nor is the present invention limited to any particular type of encapsulating material, lead frame material, or method for electrically coupling a semiconductor device to leads. Therefore, it is intended that this invention encompasses all such variations and modifications that fall within the scope of the appended claims.

## Claims

1. A semiconductor device (10) comprising:
a plurality of leads (14), each having an inner lead portion and an outer lead portion, the inner lead portions together defining an open area (18);
a substantially X-shaped metal die support member located within the open area (18), the die support member comprising four tie bars (16) and having a surface area, each tie bar having a maximum width;
a semiconductor die (20) mounted to the X-shaped die support member, the die having a surface area;
means (24) for electrically coupling the semiconductor die to the plurality of leads; and
a plastic package (28) which encapsulates the semiconductor die, the die support member, and inner lead portions of the plurality of leads;
wherein:
the surface area of the die support member equals a metal-plastic interface area; the surface area of the die minus the surface area of the die support member equals a die-plastic interface area;
the metal-plastic interface area is less than the die-plastic interface area;
at least one tie bar of the die support member has a first portion (15) having a first width and a second portion (17) having a second width larger than the first width, wherein the first and second portions converge to form shoulders, and wherein the shoulders form a die alignment feature; and
the semiconductor die overlies at least a part of the second portion of the at least one tie bar and such that each shoulder is approximately parallel to a side of the semiconductor die.

2. The semiconductor device of claim 1 wherein the die-plastic interface area is at least twice the metal-plastic interface area.

3. The semiconductor device of claim 1 wherein the semiconductor die has an outer periphery and wherein the shoulder extends beyond the outer periphery of the semiconductor die.

4. The semiconductor device of claim of any preceding claim wherein the die support member further comprises a mini-flag.

5. The semiconductor device of claim 5 wherein the mini-flag comprises a window-frame mini-flag.

6. A method for making a semiconductor device comprising the steps of:
providing a semiconductor die (20) having a side and having a backside surface;
providing a lead frame comprising:
a plurality of leads (14) having inner lead portions and outer lead portions, wherein the inner lead portions define a central open area;
a plurality of tie bars (16) which traverse the central open area and are connected to form an X-shaped die support member having a second surface area, wherein:
at least one tie bar of the plurality of tie bars has a first portion (15) having a first width and a second portion (17) having a second width larger than the first width wherein the first and second portions converge to form shoulders; and
the shoulders are an alignment feature and provides a reference point for aligning the die;
positioning the semiconductor die on the plurality of tie bars within the central open area such that the backside surface of the semiconductor die is adjacent the plurality of tie bars, and overlies at least the second portion of the at least one tie bar, and such that each shoulder is approximately parallel to a side of the semiconductor die;
electrically coupling the inner lead portions of the plurality of leads to the semiconductor die, and
encapsulating the semiconductor die with a plastic to form a package body, wherein after encapsulating, a metal-plastic interface area is created where the plurality of tie bars is in contact with the plastic and the die-plastic interface area is created where the backside of the die is in contact with the plastic; and wherein the metal-plastic interface area is less than the die-plastic interface area.

7. The method of any preceding claim wherein the die support member further comprises a mini-flag.

## Patentansprüche

1. Halbleitereinrichtung (10) umfassend:
eine Mehrzahl von Zuleitungen (14), von denen jede einen inneren Zuleitungsabschnitt und einen äußeren Zuleitungsabschnitt aufweist, wobei die inneren Zuleitungsabschnitte zusammen einen offenen Bereich (18) festlegen;
ein im Wesentlichen X-förmiges, metallisches Chipträgerelement, das innerhalb des offenen Bereichs (18) angeordnet ist, wobei das Chipträgerelement vier Verbindungsstangen (16) umfasst und eine Oberfläche hat und wobei jede Verbindungsstange eine maximale Breite hat;
ein Halbleiterchip (20), der auf dem X-förmigen Chipträgerelement angebracht ist, wobei der Halbleiterchip eine Oberfläche hat;
Mittel (24) zum elektrischen Verbinden des Halbleiterchips mit der Mehrzahl von Leitungen; und
ein Kunststoffgehäuse (28), das den Halbleiterchip, das Chipträgerelement und die inneren Zuleitungsabschnitte der Mehrzahl von Zuleitungen einkapselt;
wobei:
die Fläche der Oberfläche des Chipträgerelements gleich der Fläche einer Metall-Kunststoff-Kontaktfläche ist; die Fläche der Oberfläche des Chips minus der Fläche der Oberfläche des Chipträgerelements gleich der Fläche. einer Chip-Kunststoff-Kontaktfläche ist;
die Fläche der Metall-Kunststoff-Kontaktfläche kleiner als die Fläche der Chip-Kunststoff-Kontaktfläche ist;
zumindest eine Verbindungsstange des Chipträgerelements einen ersten Abschnitt (15) mit einer ersten Breite und einen zweiten Abschnitt (17) mit einer zweiten Breite aufweist, die größer als die erste Breite ist, wobei die ersten und die zweiten Abschnitte zusammentreffen, um Schultern zu bilden, und wobei die Schultern ein Chip-Ausrichtungsmerkmal bilden; und
der Halbleiterchip über zumindest einem Teil der zweiten Abschnitte der zumindest einen Verbindungsstange. liegt und zwar so, dass jede Schulter ungefähr parallel zu einer Seite des Halbleiterchips ist.

2. Halbleitereinrichtung nach Anspruch 1, bei der die Fläche der Chip-Kunststoff-Kontaktfläche zumindest zweimal so groß ist wie die Fläche der Metall-Kunststoff-Kontaktfläche.

3. Halbleitereinrichtung nach Anspruch 1, bei der der Halbleiterchip eine äußere Peripherie aufweist und bei der die Schulter sich über die äußere Peripherie des Halbleiterchips hinaus erstreckt.

4. Halbleitereinrichtung nach einem der vorhergehenden Ansprüche, bei der das Chipträgerelement weiter eine Minimarke aufweist.

5. Halbleitereinrichtung nach Anspruch 4, bei der die Minimarke eine Fensterrahmen-Minimarke umfasst.

6. Verfahren zum Herstellen einer Halbleitereinrichtung, umfassend die Schritte:
Bereitstellen eines Halbleiterchips (20) mit einer Seite und mit einer rückseitigen Oberfläche;
Bereitstellen eines Anschlussrahmens, umfassend:
eine Mehrzahl von Zuleitungen (14), die innere Zuleitungsabschnitte und äußere Zuleitungsabschnitte aufweisen, wobei die inneren Zuleitungsabschnitte einen zentralen offenen Bereich festlegen;
eine Mehrzahl von Verbindungsstangen (16), die den zentralen offenen Bereich durchqueren und die verbunden sind, um ein X-förmiges Chipträgerelement mit einer zweiten Oberfläche zu bilden,
wobei:
zumindest eine Verbindungsstange der Mehrzahl von Verbindungsstangen einen ersten Abschnitt (15) mit einer ersten Breite und einen zweiten Abschnitt (17) mit einer zweiten Breite aufweist, die größer als die erste Breite ist, wobei die ersten und die zweiten Abschnitte zusammentreffen, um Schultern zu bilden; und
die Schultern ein Chip-Ausrichtungsmerkmal bilden und einen Bezugspunkt für die Ausrichtung des Chips liefern;
Anordnen des Halbleiterchips auf der Mehrzahl von Verbindungsstangen innerhalb des zentralen offenen Bereichs derart, dass die rückseitige Oberfläche des Halbleiterchips benachbart zu der an die Mehrzahl von Verbindungsstangen liegt und über zumindest dem zweiten Abschnitt der zumindest einen Verbindungsstange liegt und so, dass jede Schulter ungefähr parallel zu einer Seite des Halbleiterchips ist;
elektrisches Verbinden der inneren Zuleitungsabschnitte der Mehrzahl von Zuleitungen mit dem Halbleiterchip und
Einkapseln des Halbleiterchips mit einem Kunststoff, um einen Gehäusekörper zu bilden, wobei nach dem Einkapseln eine Fläche einer Metall-Kunststoff-Kontaktfläche entsteht, in der die Mehrzahl von Verbindungsstangen in Kontakt mit dem Kunststoff steht und wobei eine Fläche einer Chip-Kunststoff-Kontaktfläche entsteht, in der die Rückseite des Chips in Kontakt mit dem Kunststoff steht; und wobei die Fläche der Metall-Kunststoff-Kontaktfläche kleiner ist als die Fläche der Chip-Kunststoff-Kontaktfläche.

7. Verfahren nach Anspruch 6, bei dem das Chipträgerelement weiter eine Minimarke umfasst.

## Revendications

1. Dispositif à semi-conducteur (10) qui comprend :
plusieurs fils de connexion (14) ayant chacun une partie interne et une partie externe de fil de connexion, les parties internes de fils de connexion délimitant ensemble une surface ouverte (18),
un organe métallique de support de pastille ayant pratiquement une forme en X, placé dans la surface ouverte (18), l'organe de support comprenant quatre barres formant tirants (16) et ayant une surface, chaque barre formant tirant ayant une largeur maximale,
une pastille semi-conductrice (20) montée sur l'organe de support de pastille en X, la pastille ayant une surface,
un dispositif (24) de couplage électrique de la pastille semi-conductrice aux fils de connexion, et
un boîtier (28) de matière plastique qui encapsule la pastille semi-conductrice, l'organe de support de pastille et les parties internes des fils de connexion,
dans lequel
la surface de l'organe de support de pastille est égale à une surface d'interface métal-plastique, et la surface de la pastille réduite de la surface de l'organe de support de pastille est égale à la surface d'interface pastille-plastique,
la surface d'interface métal-plastique est inférieure à la surface d'interface pastille-plastique,
une barre formant tirant au moins de l'organe de support de pastille possède une première partie (15) ayant une première largeur et une seconde partie (17) ayant une seconde largeur supérieure à la première largeur, la première et la seconde partie convergeant pour former des épaulements, et les épaulements formant une caractéristique d'alignement de pastille, et
la pastille semi-conductrice recouvre une partie au moins de la seconde partie de la barre formant tirant au moins, de manière que chaque épaulement soit approximativement parallèle à un côté de la pastille semi-conductrice.

2. Dispositif à semi-conducteur selon la revendication 1, dans lequel la surface d'interface pastille-plastique est au moins égale au double de la surface d'interface métal-plastique.

3. Dispositif à semi-conducteur selon la revendication 1, dans lequel la pastille semi-conductrice a une périphérie externe, et l'épaulement s'étend au-delà de la périphérie externe de la pastille semi-conductrice.

4. Dispositif à semi-conducteur selon l'une quelconque des revendications précédentes, dans lequel l'organe de support de pastille comporte en outre un mini-plateau.

5. Dispositif à semi-conducteur selon la revendication 4, dans lequel le mini-plateau comprend un mini-plateau à cadre formant une fenêtre.

6. Procédé de fabrication d'un dispositif à semi-conducteur, comprenant les étapes suivantes :
la mise à disposition d'une pastille semi-conductrice (20) possédant un côté et ayant une surface de côté arrière,
la mise à disposition d'un cadre à fils de connexion qui comprend :
plusieurs fils de connexion (14) ayant des parties internes et des parties internes de fils de connexion, les parties internes de fils de connexion délimitant une surface centrale ouverte, et
plusieurs barres formant tirants (16) disposées transversalement à la surface centrale ouverte et qui sont connectées pour former un organe de support de pastille en X ayant une seconde surface, dans lequel
une barre formant tirant au moins parmi les barres formant tirants possédant une première partie (15) ayant une première largeur et une seconde partie (17) ayant une seconde largeur supérieure à la première largeur, la première et la seconde partie convergeant pour former des épaulements, et
les épaulements formant une caractéristique d'alignement et donnent un point de référence pour l'alignement de la pastille,
le positionnement de la pastille semi-conductrice sur les barres formant tirants dans la surface centrale ouverte afin que la surface de côté arrière de la pastille semi-conductrice soit adjacente à plusieurs barres formant tirants et qu'elle recouvre au moins la seconde partie de la barre formant tirant au moins, et de manière que chaque épaulement soit approximativement parallèle à un côté de la pastille semi-conductrice,
le couplage électrique des parties internes des fils de connexion à la pastille semi-conductrice, et
l'encapsulation de la pastille semi-conductrice par une matière plastique pour la formation d'un corps de boîtier, dans lequel, après encapsulation, une surface d'interface métal-plastique est créée aux endroits où les barres formant tirants sont au contact de la matière plastique, la surface d'interface pastille-matière plastique est créée à l'endroit où le côté arrière de la pastille est au contact de la matière plastique, et la surface d'interface métal-plastique est inférieure à la surface d'interface pastille-plastique.

7. Procédé selon l'une quelconque des revendications précédentes, dans lequel l'organe de support de pastille comprend en outre un mini-plateau.
